(19) Europäisches Patentamt
European Patent Office
Office européen des brevets

(11) EP 1 630 610 B1

(12) **EUROPEAN PATENT SPECIFICATION**

(45) Date of publication and mention of the grant of the patent:
**03.06.2015 Bulletin 2015/23**

(51) Int Cl.:
*G03F 7/11* (2006.01) *G03F 7/20* (2006.01)

(21) Application number: **05017501.7**

(22) Date of filing: **11.08.2005**

(54) **Protective film-forming composition for immersion exposure and pattern forming method using the same**

Schutzfilm bildende Zusammensetzung für die Immersion-Lithographie und Verfahren zur Herstellung von Mustern unter Verwendung dieser Zusammensetzung

Composition formant un film protecteur pour lithographie par immersion et procédé de fabrication de motifs employant ladite composition

(84) Designated Contracting States:
**AT BE BG CH CY CZ DE DK EE ES FI FR GB GR HU IE IS IT LI LT LU LV MC NL PL PT RO SE SI SK TR**

(30) Priority: **11.08.2004 JP 2004234238**

(43) Date of publication of application:
**01.03.2006 Bulletin 2006/09**

(73) Proprietor: **FUJIFILM Corporation**
**Minato-ku**
**Tokyo (JP)**

(72) Inventors:
- **Kanda, Hiromi**
  **Yoshida-cho**
  **Haibara-gun**
  **Shizuoka (JP)**
- **Kanna, Shinichi**
  **Yoshida-cho**
  **Haibara-gun**
  **Shizuoka (JP)**
- **Inabe, Haruki**
  **Yoshida-cho**
  **Haibara-gun**
  **Shizuoka (JP)**

(74) Representative: **Hoffmann Eitle**
**Patent- und Rechtsanwälte PartmbB**
**Arabellastraße 30**
**81925 München (DE)**

(56) References cited:
**EP-A- 1 085 380**
**EP-A2- 1 216 830**
**EP-A2- 1 276 010**
**US-A- 5 750 312**
**US-A1- 2004 075 895**

- **SATO M: "TOK Resist & Material Development status for Immersion Lithography" LITHO FORUM, 24 January 2004 (2004-01-24), XP002350074 USA**
- **M. SWITKES ET AL.: "Immersion liquids for lithography in the deep ultraviolet" PROCEEDINGS OF THE SPIE - THE INTERNATIONAL SOCIETY FOR OPTICAL ENGINEERING, vol. 5040, 2003, pages 690-699, XP002358956 USA**

EP 1 630 610 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

1. Field of the Invention

The present invention relates to a pattern forming method using a protective film-forming composition for use in the process of producing a semiconductor such as IC or producing a circuit board of liquid crystal, thermal head or the like or in the lithography step of other photo-application processes. More specifically, the present invention relates to a pattern forming method using a protective film-forming composition suitable for exposure by an immersion-type projection exposure apparatus using a light source of emitting far ultraviolet light at a wavelength of 300 nm or less.

2. BACKGROUND ART

Along with the refinement of semiconductor devices, the trend is moving into shorter wavelength of exposure light source and higher numerical aperture (high NA) of projection lens. At present, exposure machines with NA of 0.84 have been developed, where an ArF excimer laser having a wavelength of 193 nm is used as the light source. As commonly well known, these can be expressed by the following formulae:

$$(\text{Resolving power}) = k_1 \cdot (\lambda/NA)$$

$$(\text{Focal depth}) = \pm k_2 \cdot \lambda/NA^2$$

wherein $\lambda$ is the wavelength of exposure light source, NA is the numerical aperture of projection lens, and $k_1$ and $k_2$ are constants related to the process.

In order to realize still shorter wavelength and higher resolving power, studies are being made on exposure machines where an $F_2$ excimer laser having a wavelength of 157 nm is used as the light source. However, the lens material used for the exposure apparatus so as to realize shorter wavelength and the material used for the resist are very limited and therefore, it is extremely difficult to stabilize the production cost or quality of the apparatus and materials. This may lead to a failure in procuring the exposure apparatus and resist having sufficiently high performance and stability within a required time period.

With respect to the technique of elevating the resolving power in optical microscopes, a so-called immersion method of filling a high refractive-index liquid (hereinafter sometimes referred to as an "immersion liquid") between the projection lens and the sample has been conventionally known.

As for the "effect of immersion", assuming that the wavelength of exposure light in air is $\lambda_0$, the refractive index of immersion liquid to air is n, the convergence half-angle of beam is $\theta$ and $NA_0=\sin\theta$, the above-described resolving power and focal depth when immersed can be expressed by the following formulae:

$$(\text{Resolving power}) = k_1 \cdot (\lambda_0/n)/NA_0$$

$$(\text{Focal depth}) = \pm k_2 \cdot (\lambda_0/n)/NA_0^2$$

That is, the effect of immersion is equal to use of an exposure wavelength of 1/n. In other words, in the case of a projection optical system with the same NA, the focal depth can be made n times larger by the immersion.

This is effective for all pattern profiles and can be combined with super-resolution techniques such as phase-shift method and modified illumination method which are being studied at present.

Examples of the apparatus where this effect is applied to the transfer of a fine image pattern of semiconductor device include those described in Patent Document 1 (JP-B-57-153433 (the term "JP-B" as used herein means an "examined Japanese patent publication")), Patent Document 2 (JP-A-7-220990 (the term "JP-A" as used herein means an "unexamined published Japanese patent application")) and Patent Document 3 (JP-A-6-124873), but these patent publications are not discussing on a resist suitable for immersion exposure techniques.

Patent Document 4 (JP-A-10-303114) indicates that the control of refractive index of the immersion liquid is important because change in the refractive index of immersion liquid causes deterioration of the projected image due to wavefront aberration of the exposure machine, and discloses a technique of controlling the temperature coefficient of refractive index of the immersion liquid to fall within a certain range and using, as a suitable immersion liquid, water

where an additive of decreasing the surface tension or increasing the surface activity is added. However, the additive is not disclosed or the resist suitable for immersion exposure techniques is not discussed.

Recent progress of immersion exposure techniques is reported, for example, in Non-Patent Document 1 (SPIE Proc., 4688, 11 (2002)) and Non-Patent Document 2 (J. Vac. Sci. Tecnol. B, 17 (1999)). In the case of using an ArF excimer laser as the light source, in view of safety on handling as well as transmittance and refractive index at 193 nm, pure water (refractive index at 193 nm: 1.44) is considered to be a most promising immersion liquid.

In the case of using an $F_2$ excimer laser as the light source, a fluorine-containing solution is being studied in the light of balance between transmittance and refractive index at 157 nm, but those satisfied in view of environmental safety or refractive index have been not yet found out. Considering the degree of immersion effect and the maturity of resist, the immersion exposure technique is expected to be most soon mounted on an ArF exposure machine.

Since the discovery of resist for KrF excimer laser (248 nm), an image forming method called chemical amplification is used as the image forming method for the resist so as to compensate the reduction of sensitivity due to light absorption. According to this image forming method, for example, in the case of using positive chemical amplification, an acid generator in the exposed area decomposes upon exposure to generate an acid, the acid generated is used as a reaction catalyst in the post-exposure baking (PEB) to convert the alkali-insoluble group into an alkali-soluble group, and the exposed area is removed by an alkali development.

In the immersion exposure, the resist film is exposed through a photomask in the state that an immersion liquid is filled between the resist film and the optical lens, and thereby the pattern of the photomask is transferred to the resist film. At this time, the immersion liquid sometimes permeates into the inside of the resist film to cause failure of image formation (Non-Patent Document 3: Nikkei Microdevice (April, 2004)). Also, it is feared that an organic material or the like dissolves out from the resist film into the immersion liquid and this gives rise to mingling of impurities in the immersion liquid and contamination of the lens or exposure apparatus, as a result, the exposure is inhibited.

In order to overcome such a problem, a method of providing a protective film (hereinafter sometimes referred to as "a topcoat" or "an overcoat") between the resist film and the lens, thereby preventing direct contact between the resist and the water, is known (see, for example, Non-Patent Document 3).

However, those having satisfactory performance as the material for the topcoat are not yet known.

M. Sato, "TOK Resist & Material Development Status for Immersion Lithography", Litho Forum, Los Angeles, January 28, 2004, describes a feasibility study on 193 nm immersion lithography resulting in a structure comprising a substrate, an acrylate resist and a protective film ("TSP-3A") covered by the immersion liquid ("DIW").

## Summary of the Invention

An object of the present invention is to provide an immersion exposure pattern forming method capable of forming a protective film soluble in an alkali developer on a resist film, that is, a protective film which in the pattern formation by immersion exposure, protects the resist film from the immersion liquid, undergoes no swelling with the immersion liquid, is removable with an alkali developer used in the developing step and allows for formation of a good pattern.

The present invention provides a pattern forming method using a protective film-forming composition having the following constitutions and by these composition and pattern forming method, the above-described object can be attained.

(1) A pattern forming method comprising: forming a resist film; forming a protective film on the resist film by using a protective film-forming composition ; and subjecting the resist film to immersion exposure through the protective film and then to development, wherein the protective film-forming composition comprises a water-insoluble alkali-soluble resin having an acid value of 2.0 to 8.0 milli-equivalent/g.

(2) The pattern forming method as described in (1) above, wherein the protective film is formed by coating the protective film-forming composition and heating the coating at 60 to 100°C.

(3) The pattern forming method as described in (1) above, wherein the composition further comprises a surfactant.

(4) The pattern forming method as described in (1) above, wherein the solid content concentration of the composition is from 1 to 5 mass%.

(5) The pattern forming method as described in (1) above, wherein the content of compounds having a molecular weight of 3,000 or less in the resin is 5 mass% or less.

The protective film-forming composition used in the present invention can form a protective film removable with an alkali developer and capable of preventing the immersion liquid (particularly, water in ArF immersion lithography) from permeating into the inside of the resist film and preventing the resist film components from dissolving out into the immersion liquid. That is, according to the present invention, a protective film-forming composition in used for giving a protective film which protects the resist film from the immersion liquid and allows for formation of a good pattern in the

pattern formation by immersion exposure, and an immersion exposure pattern forming method using the composition can be provided.

Brief Description of the Drawing

Fig. 1 is a view schematically showing a two-beam interference exposure testing apparatus.

Description of Numerical References

1 Laser
2 Diaphragm
3 Shutter
4, 5 and 6 Reflecting mirror
7 Condenser lens
8 Prism
9 Immersion liquid
10 Wafer having provided thereon antireflection film, resist film and protective film
11 Wafer stage

DETAILED DESCRIPTION OF THE INVENTION

The present invention is described in detail below.

[1] Water-insoluble alkali-soluble resin having acid value of 2.0 to 8.0 milli-equivalent/g

The protective film-forming composition for immersion exposure used in the present invention contains a water-insoluble alkali-soluble resin having an acid value of 2.0 to 8.0 milli-equivalent/g (hereinafter sometimes referred to as a "resin (X)").

The resin (X) is alkali-soluble and contains an alkali-soluble group. Examples of the alkali-soluble group include a phenolic hydroxyl group, a carboxylic acid group, a fluorinated alcohol group, a sulfonic acid group, a sulfonamide group, $-CONHSO_2$ and a group having an active methylene group. Among these, a carboxylic acid group and a fluorinated alcohol group are preferred.

Examples of the group having an active methylene group include $-C(=O)-CH_2-C(=O)-$, $-C(=O)-CHR-C(=O)-$ (wherein R is an alkyl group), $-C(=O)-CH(C(=O))_2-$ and $-SO_2-CH_2-C(=O)-$.

The fluorinated alcohol group is a fluoroalkyl group substituted with at least one hydroxyl group and is preferably a fluoroalcohol group having from 1 to 10 carbon atoms, more preferably from 1 to 5 carbon atoms. Specific examples of the fluoroalcohol group include - $CF_2OH$, $-CH_2CF_2OH$, $-CH_2CF_2CF_2OH$, $-C(CF_3)_2OH$, $-CF_2CF (CF_3) OH$ and $-CH_2C(CF_3)_2OH$. Among these fluoroalcohol groups, - $C(CF_3)_2OH$ is preferred.

The acid value is from 2.0 to 8.0 milli-equivalent/g, preferably from 3.0 to 6.0 milli-equivalent/g, more preferably from 3.0 to 5.0 milli-equivalent/g.

The acid value is determined by measuring the amount (mg) of potassium hydroxide necessary for neutralizing the compound.

In the synthesis of the resin (X), the number of acid groups in the monomer and the molecular weight, compositional ratio or the like of the monomer are adjusted to control the number of acid groups in the resin, whereby a resin having a desired acid value can be obtained.

Examples of the acid group include those described above as examples of the alkali-soluble group.

Examples of the resin (X) include an acrylic resin, a methacrylic resin, a styrene-based resin, a novolak resin, a polyvinyl alcohol-based resin, and a resin where a fluorine atom is bonded to the carbon atom in the main chain.

More specifically, examples thereof include the resins containing a repeating unit represented by any one of the following formulae (I) to (VI).

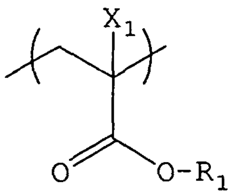

(I)

wherein $X_1$ represents a hydrogen atom, a methyl group, a halogen atom or a methyl halide group, and $R_1$ represents a hydrogen atom or an organic group.

Examples of the halogen atom and the halogen atom in the methyl halide group include a fluorine atom, a chlorine atom, a bromine atom and an iodine atom. Among these, a fluorine atom is preferred.

The organic group as $R_1$ is preferably an organic group having from 3 to 20 carbon atoms, more preferably from 5 to 15 carbon atoms, and examples thereof include an alkyl group, a cycloalkyl group, an aryl group and an aralkyl group.

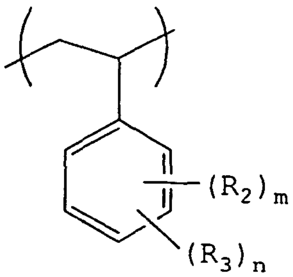

(II)

wherein $R_2$ represents an organic group, $R_3$ represents a hydroxyl group or an alkali-soluble group, m and n each independently represents a number of 0 to 5, and m+n=0 to 5.

The organic group as $R_2$ is the same as the organic group as $R_1$ in formula (I).

The alkali-soluble group as $R_3$ is the same as those described above.

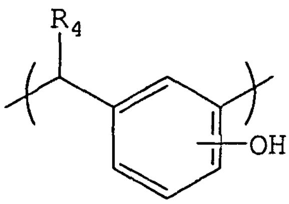

(III)

wherein $R_4$ represents a hydrogen atom or an organic group.

The organic group as $R_4$ is preferably an organic group having from 1 to 20 carbon atoms, more preferably from 1 to 6 carbon atoms, and examples thereof include an alkyl group, a cycloalkyl group, an aryl group and an aralkyl group.

Preferred examples of the substituent which the organic group of R may have include a halogen atom (preferably fluorine atom).

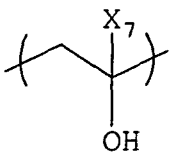

(IV)

wherein $X_7$ represents a hydrogen atom, a methyl group, a halogen atom or a methyl halide group. The details thereof are the same as $X_1$ in formula (I).

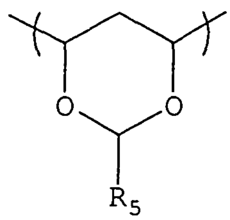

(V)

wherein $R_5$ represents an alkali-soluble group or an organic group.

The alkali-soluble group as $R_5$ is the same as the alkali-soluble group as $R_3$ in formula (II).

The organic group as $R_5$ is the same as the organic group as $R_1$ in formula (I).

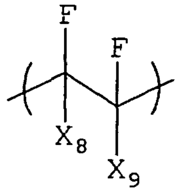

(VI)

wherein $X_8$ and $X_9$ each independently represents a hydrogen atom, a fluorine atom or a fluorinated alkyl group. At least one of $X_8$ and $X_9$ is preferably a fluorine atom.

The fluorinated alkyl group as $X_8$ and $X_9$ is preferably a fluorinated alkyl group having from 1 to 6 carbon atoms, more preferably from 1 to 3 carbon atoms. The number of fluorine atoms is preferably from 1 to 20, more preferably from 3 to 8.

In these formulae, the organic group as $R_1$, $R_2$, $R_4$ and $R_5$ is preferably an alkyl group or a fluorinated alkyl group.

The alkali-soluble group as $R_3$ and $R_5$ is preferably a carboxylic acid group or a fluorinated alcohol group.

The resin (X) is preferably transparent to light of the exposure light source used so that the light can reach the resist film through the protective film upon exposure. In use for ArF immersion exposure, from the standpoint of transparency to ArF light, the resin (X) preferably has no aromatic group.

The resin (X) may contain other repeating structural unit together with the above-described repeating structural unit. Examples of the monomer constituting the other repeating structural unit include compounds having one addition-polymerizable unsaturated bond selected from acrylic acid esters, methacrylic acid esters, acrylamides, methacrylamides, allyl compounds, vinyl ethers and vinyl esters. In addition, an addition-polymerizable compound copolymerizable with a monomer corresponding to the above-described various repeating structural units may also be copolymerized.

In the resin (X), the content of the repeating unit represented by formula (I) is preferably from 10 to 100 mol%, more preferably from 30 to 100 mol%, based on all repeating units constituting the resin (X).

The content of the repeating unit represented by formula (II) is preferably from 10 to 100 mol%, more preferably from 30 to 100 mol%, based on all repeating units constituting the resin (X).

The content of the repeating unit represented by formula (III) is preferably from 10 to 100 mol%, more preferably from 30 to 100 mol%, based on all repeating units constituting the resin (X).

The content of the repeating unit represented by formula (IV) is preferably from 30 to 100 mol%, more preferably from 50 to 100 mol%, based on all repeating units constituting the resin (X).

The content of the repeating unit represented by formula (V) is preferably from 10 to 100 mol%, more preferably from 30 to 100 mol%, based on all repeating units constituting the resin (X).

The content of the repeating unit represented by formula (VI) is preferably from 30 to 100 mol%, more preferably from 50 to 100 mol%, based on all repeating units constituting the resin (X).

Within these ranges, both insolubility in water and solubility in an alkali developer can be satisfactorily achieved.

Specific preferred examples of the resin (X) are set forth below, but the present invention is not limited thereto.

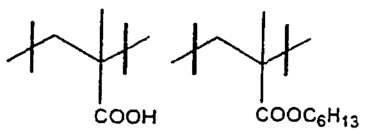

(I-1)

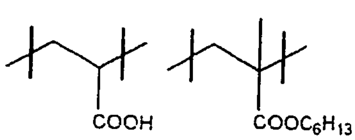

(I-2)

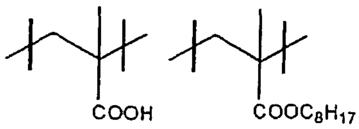

(I-3)

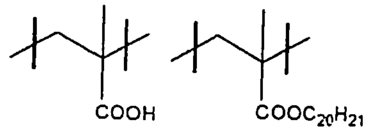

(I-4)

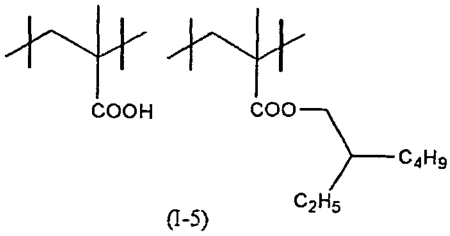

(I-5)

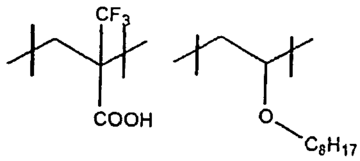

(I-6)

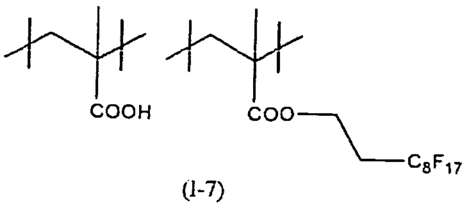

(I-7)

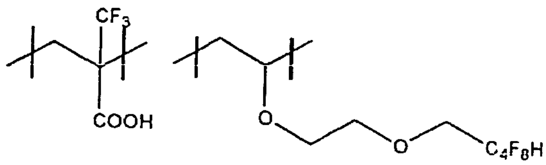

(I-8)

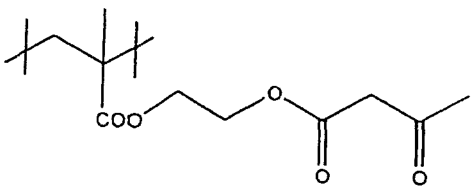

(I-9)

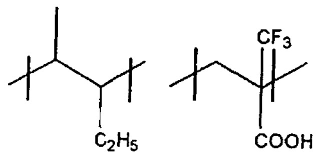

(I-10)

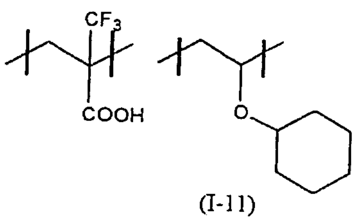

(I-11)

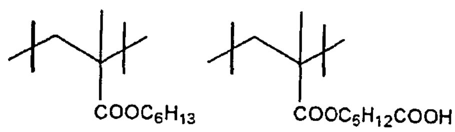

(I-12)

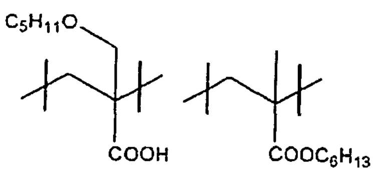

(I-13)

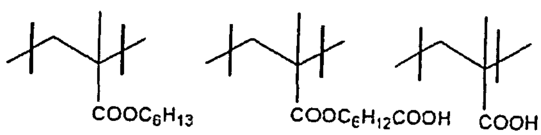

(I-14)

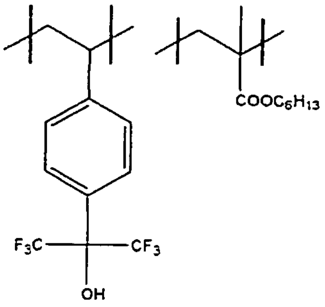

(I-15)

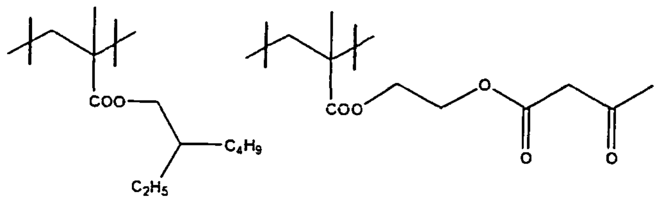

(I-16)

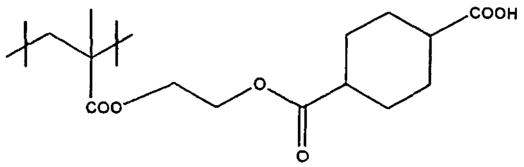

(I-17)

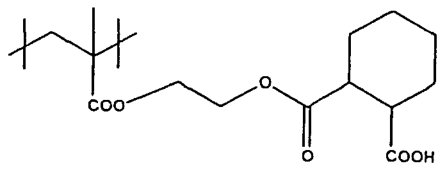

(I-18)

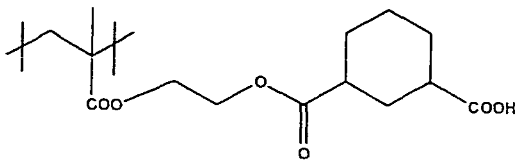

(I-19)

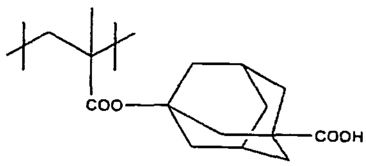

(I-20)

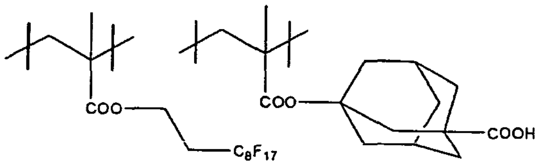

(I-21)

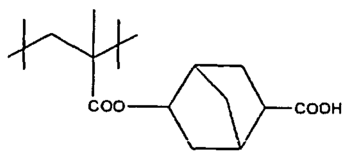

(I-22)

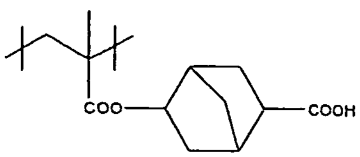

(I-23)

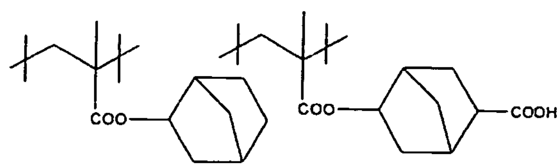

(I-24)

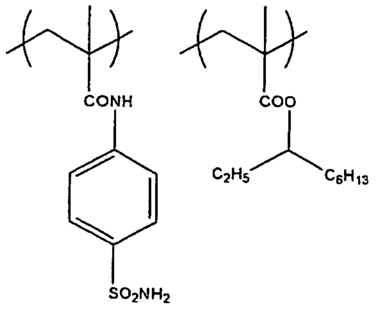

(I-25)

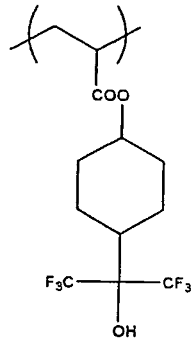

(I-26)

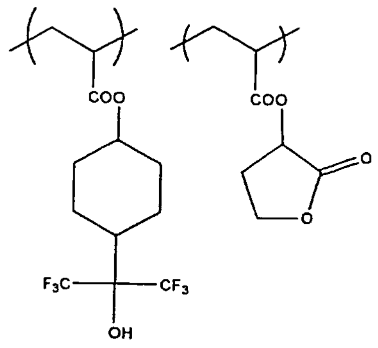

(I-27)

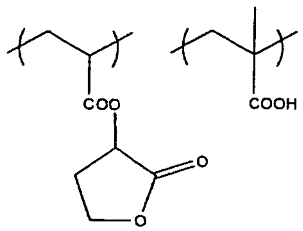

(I-28)

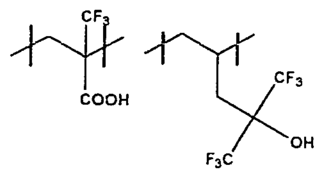

(I-29)

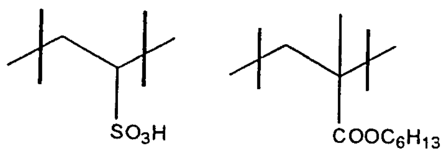

(I-30)

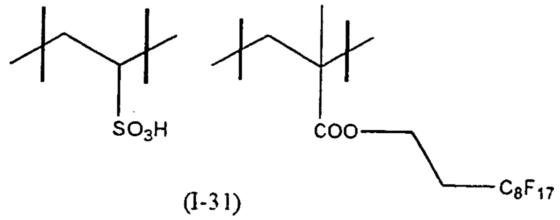

(I-31)

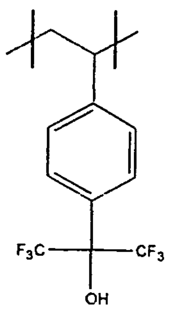

(II-1)

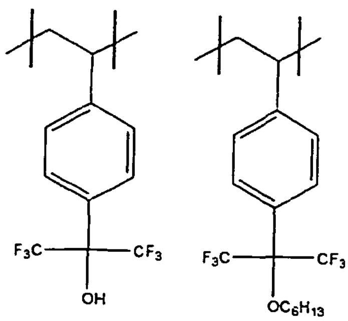

(II-2)

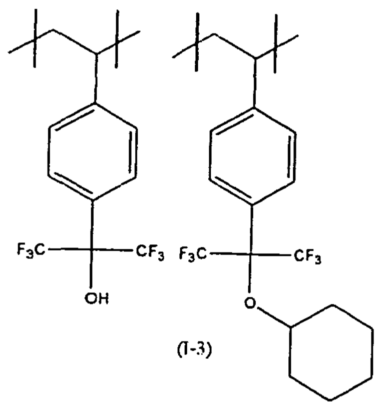

(I-3)

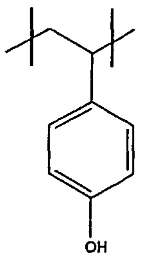

(II-4)

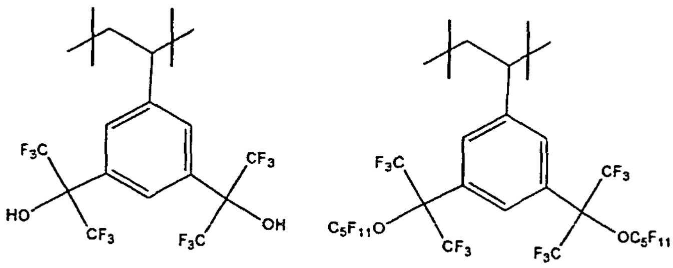

(II-5)

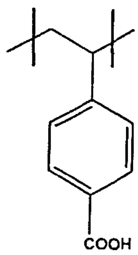

(II-6)

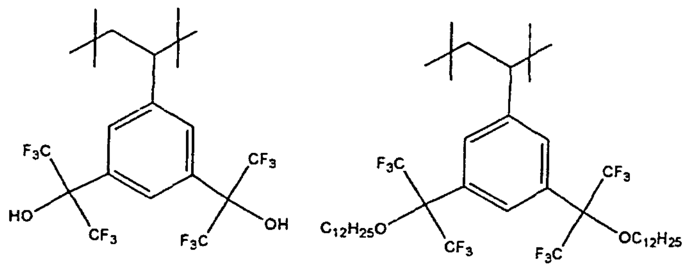

(II-7)

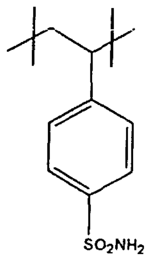

(II-8)

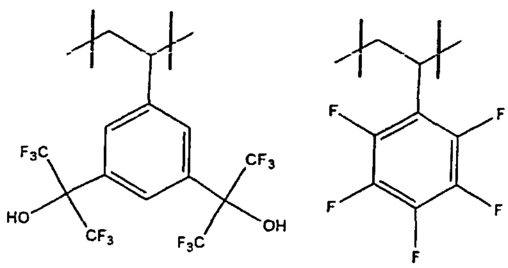

(II-9)

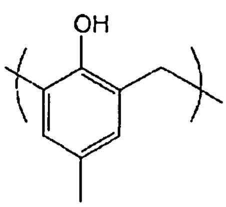

(III-1)

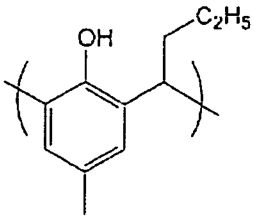

(III-2)

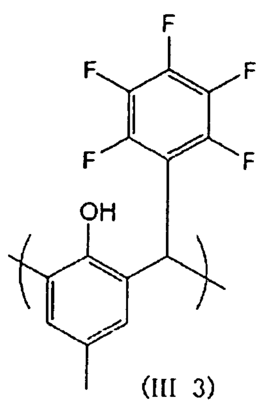

(III 3)

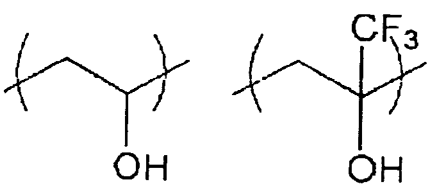

(IV-1)

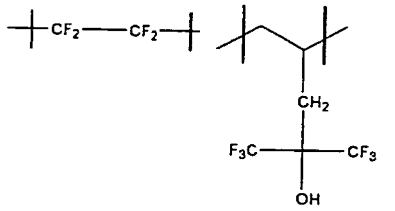

(VI-1)

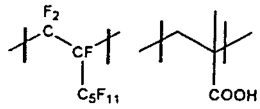

(VI-2)

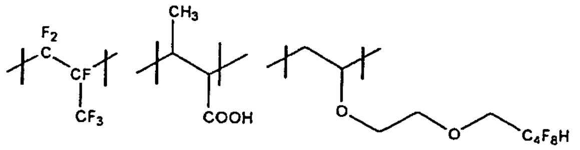

(VI-3)

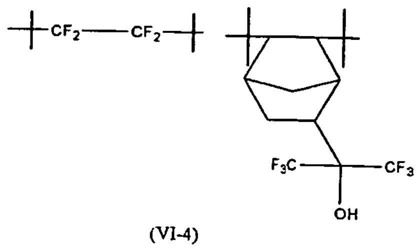

(VI-4)

The resin (X) has an acid value of 2.0 to 8,0 milli-equivalent/g and has a property desired as the resin constituting the protective film, that is, the resin is water-insoluble and alkali-soluble.

When a protective film comprising the water-insoluble resin (X) intervenes between the resist film and the immersion liquid, the immersion liquid is prevented from permeating into the inside of the resist film and at the same time, the resist components are prevented from dissolving out into the immersion liquid, so that a proper pattern can be obtained in the pattern formation by immersion exposure.

Also, the resin (X) is alkali-soluble and therefore, the protective film can be easily dissolved and removed by alkali development without separately providing a step of removing the protective film.

The term "water-insoluble" as used herein indicates a property such that when a solution obtained by dissolving the resin in a solvent is coated on a silicon wafer and dried and after dipping the formed film in pure water at 23°C for 10 minutes and drying it, the film thickness is measured, the film thickness is not decreased.

The term "alkali-soluble" means that the resin is soluble in an alkali developer used for the development in the pattern formation using a resist, and this indicates a property such that when a solution obtained by dissolving the resin in a solvent is coated on a silicon wafer and dried and after the film is treated with an aqueous 2.38 mass% tetramethylammonium hydroxide solution at 23°C for 30 seconds, rinsed with pure water for 30 seconds and dried, the film thickness is measured, the film thickness becomes zero.

The resin (X) can be synthesized in a usual manner (for example, by radical polymerization).

For example, in a general synthesis method, a monomer species is charged into a reaction vessel en bloc or on the way of reaction, dissolved and homogenized, if desired, in a reaction solvent such as ethers (e.g., tetrahydrofuran, 1,4-dioxane, diisopropyl ether), ketones (e.g., methyl ethyl ketone, methyl isobutyl ketone), ester solvents (e.g., ethyl ester) and solvents of dissolving the composition of the present invention (e.g., propylene glycol monomethyl ether acetate which is described later), and then heated, if desired, in an inert gas atmosphere such as nitrogen and argon, and the polymerization is initiated by using a commercially available radical initiator (e.g., azo-based initiator, peroxide). If desired, the initiator is added additionally or in parts. After the completion of reaction, the reaction product is charged into a solvent and the desired polymer is recovered in the form of a powder or a solid. The reaction concentration is usually 20 mass% or more, preferably 30 mass% or more, more preferably 40 mass% or more, and the reaction temperature is usually from 10 to 150°C, preferably from 30 to 120°C, more preferably from 50 to 100°C.

The resin (X) can be synthesized not only by the above-described radical polymerization but also by various methods. Other than the radical polymerization, the resin can be synthesized, for example, by cationic polymerization, anionic polymerization, addition polymerization, cyclic polymerization, polyaddition, polycondensation or addition-condensation.

In addition, various commercially available resins may also be used.

The above-described repeating structural units each may be used alone or as a mixture of two or more thereof. Also, in the present invention, the resins may be used individually or in combination of two or more thereof.

The weight average molecular weight of the resin (X) is, in terms of polystyrene-reduced value by gas permeation chromatography (GPC), preferably 1,000 or more, more preferably from 1,000 to 200,000, still more preferably from 3,000 to 20,000.

From the standpoint of preventing the dissolving-out of components, the content of the compound having a molecular weight of 3,000 or less (low-molecular component) such as monomer in the resin (X) is preferably 5 mass% or less, more preferably 3 mass% or less.

The content of the low-molecular component in the resin can be measured by NMR or GPC.

The molecular weight distribution (Mw/Mn, also called "dispersity") is usually from 1 to 5, preferably from 1 to 4, more preferably from 1 to 3.

In the protective film-forming composition of the present invention, the amount of the resin (X) blended is preferably from 60 to 100 mass%, more preferably from 70 to 100 mass%, based on the entire solid content of the protective film-forming composition.

The protective film-forming composition usually contains a solvent and, if desired, may further contain a surfactant and other components. These components are described below.

[2] Solvent

The protective film-forming composition for immersion exposure used in the present invention is prepared usually by dissolving the components described above in a predetermined organic solvent. The solvent is preferably different from the organic solvent used for the resist so as to avoid admixing with resist. Also, from the standpoint of preventing the dissolving-out into the immersion liquid, the solvent is preferably water-insoluble. Furthermore, a solvent having a boiling point of 100 to 200°C is preferred.

In the present invention, one solvent may be used or a plurality of solvents may be mixed and used.

Examples of the solvent which can be used include the followings:

hydrocarbon-based solvents such as benzene, toluene, ethylbenzene, amylbenzene, isopropylbenzene, hexane, heptane, octane, nonane, decane, dodecane, cyclohexane, methylcyclohexane, p-menthane, decalin, xylene, cyclohexylbenzene, cyclohexene, cyclopentane, dipentene, naphthalene, dimethylnaphthalene, cymene, tetralin, biphenyl and mesitylene;

hydrogenated hydrocarbon solvents such as methylene chloride, hexyl chloride, chlorobenzene and bromobenzene;

alcohols such as amyl alcohol, isoamyl alcohol, butanol, hexanol, 3-heptanol, i-butyl alcohol, 2-ethyl butanol, 2-ethyl hexanol, octanol, nonanol, neopentyl alcohol, cyclohexanone, tetrahydrofurfuryl alcohol;

nitrogen-containing solvents such as acetonitrile, isopropanolamine, ethylhexylamine, N-ethylmorpholine, diisopropylamine, cyclohexylamine, di-n-butylamine, tetramethylethylenediamine and tripropylamine;

carboxylic acid-based solvents such as formic acid, acetic acid, butyric acid, isobutyric acid, itaconic acid and propionic acid;

acid anhydride-based solvents such as acetic anhydride, propionic anhydride and itaconic anhydride;

fluorine-based solvents such as 1,4-difluorobenzene, 1,1,2,2-tetrachlorodifluoroethane, tetrafluoropropanol, ethyl trifluoroacetoacetate, perfluoroheptane, hexafluoroisopropanol, perfluorobutylethanol, pentafluoro-propanol, hexafluorobenzene, perfluorobutyltetrahydrofuran, perfluoropolyethers and fluorophenols; and

others such as anisole, dioxane, dioxolane, dibutyl ether, ethyl-n-methyl-n-butyl ketone, ethylene glycol, diglycidyl ether, ethylene dichloride, cyclohexanone, cyclopentanone, 2-heptanone, γ-butyrolactone, methyl ethyl ketone, ethylene glycol, ethylene glycol monomethyl ether, ethylene glycol monoethyl ether, 2-methoxyethyl acetate, ethylene glycol monoethyl ether acetate, propylene glycol, propylene glycol monomethyl ether, propylene glycol monomethyl ether acetate, toluene, ethyl acetate, methyl lactate, ethyl lactate, methyl methoxy propionate, ethyl ethoxy propionate, methyl pyruvate, ethyl pyruvate, propyl pyruvate, N,N-dimethylformamide, dimethylsulfoxide, N-methylpyrrolidone, methoxybutanol, tetrahydrofuran, ethyl ethoxy propionate, butyl acetate and N,N-dimethylacetamide.

[3] Surfactant

The protective film-forming composition used in the present invention may further contain a surfactant. As for the surfactant, it is preferred to contain any one of or two or more of fluorine-containing and/or silicon-containing surfactants (a fluorine-containing surfactant, a silicon-containing surfactant and a surfactant containing both a fluorine atom and a silicon atom). By containing this surfactant, generation of striation is suppressed and coating uniformity is enhanced.

Examples of the fluorine-containing and/or silicon-containing surfactant include surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include fluorine-containing surfactants and silicon-containing surfactants, such as EFtop EF301 and EF303 (produced by Shin-Akita Kasei K.K.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical). In addition, polysiloxane polymer KP-341 (produced by Shin-Etsu Chemical Co., Ltd.) may also be used as the silicon-containing surfactant.

Other than those known surfactants, surfactants using a polymer having a fluoro-aliphatic group, which is derived from a fluoro-aliphatic compound produced by telomerization (also called telomer process) or oligomerization (also called oligomer process), may be used. The fluoro-aliphatic compound can be synthesized by the method described in JP-A-2002-90991.

The polymer having a fluoro-aliphatic group is preferably a copolymer of a fluoro-aliphatic group-containing monomer with (poly(oxyalkylene)) acrylate and/or (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene group). This group may also be a unit having alkylenes differing in the chain length within the same chain, such as block-linked poly(oxyethylene, oxypropylene and oxyethylene) and block-linked poly(oxyethylene and oxypropylene). Furthermore, the copolymer of a fluoro-aliphatic group-containing monomer and a (poly(oxyalkylene)) acrylate (or methacrylate) may be not only a binary copolymer but also a ternary or greater copolymer obtained by simultaneously copolymerizing two or more different fluoro-aliphatic group-containing monomers or two or more different (poly(oxyalkylene)) acrylates (or methacrylates).

Examples thereof include commercially available surfactants such as Megafac F178, F-470, F-473, F-475, F-476 and F-472 (produced by Dainippon Ink & Chemicals, Inc.). Other examples include copolymers of an acrylate (or methacrylate) having a $C_6F_{13}$ group with a (poly(oxyalkylene)) acrylate (or methacrylate), copolymers of an acrylate (or methacrylate) having a $C_6F_{13}$ group with a (poly(oxyethylene)) acrylate (or methacrylate) and a (poly(oxypropylene)) acrylate (or methacrylate), copolymers of an acrylate (or methacrylate) having a $C_8F_{17}$ group with a (poly(oxyalkylene)) acrylate (or methacrylate), and copolymers of an acrylate (or methacrylate) having a $C_8F_{17}$ group with a (poly(oxyethylene)) acrylate (or methacrylate) and a (poly(oxypropylene)) acrylate (or methacrylate).

In the present invention, surfactants other than the fluorine-containing and/or silicon-containing surfactants can also be added. Specific examples thereof include nonionic surfactants such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene-polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate).

One of these surfactants may be used alone or some of these surfactants may be used in combination.

The amount of the surfactant used is preferably from 0.0001 to 2 mass%, more preferably from 0.001 to 1 mass%, based on the entire amount (excluding the solvent) of the protective film-forming composition for immersion exposure.

In the protective film-forming composition for immersion exposure of the present invention, the concentration of all solid contents such as resin and surfactant is preferably from 1 to 5 mass%.

[4] Protective Film

The protective film-forming composition for immersion exposure used in the present invention is applied onto the resist film by coating or the like to form a protective film, and the protective film prevents the immersion liquid from permeating into the inside of the resist film and also prevents the resist film components from dissolving out into the immersion liquid. The coating means is not particularly limited and may be appropriately selected according to the process applied. For example, spin coating may be used.

The protective film is preferably transparent to light of the exposure light source and in view of this point, the film thickness is preferably smaller and the protective film is usually formed to a thickness of 1 to 300 nm, preferably from 10 to 150 nm. The exposure light transmittance of the film is preferably from 50 to 80%, more preferably from 60 to 70%. The exposure light transmittance can be adjusted, for example, by controlling the polymerization components of the resin. For instance, when the amount of the aromatic ring contained in the resin is decreased, the transmittance for ArF light can be elevated.

Also, dissolving-out from the protective film preferably less occurs so that the immersion liquid or lens can be prevented from contamination with components dissolved out from the protective film.

In view of affinity of the protective film for the immersion liquid, the contact angle (at 23°C) of the immersion liquid to the protective film is preferably from 50 to 80°, more preferably from 60 to 80°. The contact angle can be adjusted to this range by controlling the amount of the acid group or controlling the hydrophilicity/hydrophobicity of the copolymerization components.

The refractive index of the protective film is, in view of resolution, preferably close to the refractive index of the resist film. The refractive index can be adjusted by controlling the components of the protective film-forming composition, particularly, the composition of resin and the ratio of repeating units.

When forming a protective film, it is preferred that the protective film-forming composition can be uniformly

coated. The coatability (coating uniformity) can be improved by appropriately selecting the kind of solvent or the surfactant or other additives and controlling the amount added thereof.

The resist pattern formed preferably has no electrical conductivity and similarly, the protective composition for immersion exposure preferably contains no metal. The metal content in the protective film-forming composition is preferably 100 ppb or less, more preferably 50 ppb or less. The metal content can be decreased by elevating the purity of materials used or by normal purification such as filtration.

The protective film-forming composition for immersion exposure is coated on a resist film to form a film and therefore, the composition preferably causes no admixing with the resist film at the interface.

The dissolution rate of the protective film in an alkali developer is preferably more than 300 nm/sec, more preferably from more than 300 nm/sec to 10,000 nm/sec. The dissolution rate is a value measured at 23°C in an aqueous 2.38 mass% tetramethylammonium solution as the alkali developer by using a resist dissolution rate analyzer (RDA790) manufactured by Litho Tech Japan Corp.

[5] Pattern Forming Method

The protective film-forming composition for immersion exposure of the present invention is usually used by dissolving the above-described components in a solvent and applying the obtained solution to a resist film on a substrate.

More specifically, a resist composition for immersion exposure is coated on such a substrate as used in the production of precision integrated circuit elements, to an arbitrary thickness (usually from 50 to 500 nm) by an appropriate coating method such as spinner and coater. At this time, it is also preferred to form the resist film after providing an appropriate antireflection film on the substrate. The coating is then dried by spinning or baking to form a resist film.

Similarly to the resist composition, the protective film-forming composition for immersion exposure is coated on the resist film by using a spinner, a coater or the like, and then dried by spinning or baking to form a protective film.

The baking temperature is preferably from 60 to 100°C.

Thereafter, exposure via immersion liquid (immersion exposure) is performed through a mask for the pattern formation.

The exposure amount can be appropriately set but is usually from 1 to 100 mJ/cm$^2$. After the exposure, spinning and/or baking is preferably performed, and development and rinsing are performed, whereby a pattern is obtained. In the present invention, the protective film is dissolved or removed with the developer in the development step and therefore, a removal step need not be separately provided.

After the exposure, baking is preferably performed. The baking temperature is usually from 30 to 300°C. Considering the change in the line width of resist pattern due to fluctuation in the post-exposure time delay (PED) from exposure until development, the time from exposure until the baking step is preferably shorter.

The exposure light is preferably a far ultraviolet ray at a wavelength of 250 nm or less, more preferably 220 nm or less. Specific examples thereof include KrF excimer laser (248 nm), ArF excimer laser (193 nm), $F_2$ excimer laser (157 nm) and X-ray.

Examples of the substrate which can be used include a normal bare Si substrate, an SOG substrate and a substrate with antireflection film.

The antireflection film which can be used includes an inorganic film type such as titanium, titanium dioxide, titanium nitride, chromium oxide, carbon and $\alpha$-silicon, and an organic film type comprising a light absorber and a polymer material. The former requires equipment for the film formation, such as vacuum deposition apparatus, CVD apparatus and sputtering apparatus. Examples of the organic antireflection film include a film comprising a light absorber, an alkali-soluble resin and a condensate of a diphenylamine derivative and a formaldehyde-modified melamine resin described in JP-B-7-69611, a reaction product of a maleic anhydride copolymer with a diamine-type light absorber described in U.S. Patent 6,294,680, a film comprising a resin binder and a methylolmelamine-based thermal crosslinking agent described in JP-A-6-118631, an acrylic resin-type antireflection film having a carboxylic acid group, an epoxy group and a light-absorbing group in the same molecule described in JP-A-6-118656, a film comprising methylolmelamine and a benzophenone-based light absorber described in JP-A-8-87115, and a film comprising a polyvinyl alcohol resin having added thereto a low-molecular light absorber described in JP-A-8-179509.

Furthermore, for example, DUV-30 Series, DUV-40 Series and ARC25 produced by Brewer Science Inc., and AC-2, AC-3, AR19 and AR-20 produced by Cipray, may also be used as the organic antireflection film.

The immersion liquid used in the immersion exposure is described below.

The immersion liquid is preferably a liquid transparent to light at the exposure wavelength and having a small temperature constant of refractive index as much as possible so as to minimize the distortion of an optical image projected on the resist. Particularly, when the exposure light source is an ArF excimer laser (wavelength: 193 nm), water is preferably used in view of easy availability and easy handleability, in addition to the above-described aspects.

In the case of using water as the immersion liquid, for the purpose of decreasing the surface tension of water and increasing the surface activity, an additive (liquid) which does not dissolve the resist layer on a wafer and at the

same time, gives only a negligible effect on the optical coat on the lower surface of the lens element may be added at a small ratio. The additive is preferably an aliphatic alcohol having a refractive index nearly equal to that of water, and specific examples thereof include methyl alcohol, ethyl alcohol and isopropyl alcohol. By adding an alcohol having a refractive index nearly equal to that of water, even when the alcohol component in water is evaporated and changed in the content concentration, the change in the refractive index of the entire liquid can be advantageously made very small. On the other hand, if a substance opaque to light at 193 nm or an impurity greatly differing in the refractive index from water is mingled, this incurs distortion of the optical image projected on the resist. Therefore, the water used is preferably distilled water. Pure water after further filtration through an ion exchange filter or the like may also be used.

The electrical resistance of water is preferably 18.3 M-ohm·cm or more, and TOC (organic material concentration) is preferably 20 ppb or less. Also, the water is preferably subjected to a deaeration treatment.

As for the alkali developer used in the development step, an alkaline aqueous solution can be used and examples thereof include inorganic alkalis such as sodium hydroxide, potassium hydroxide, sodium carbonate, sodium silicate, sodium metasilicate and aqueous ammonia, primary amines such as ethylamine and n-propylamine, secondary amines such as diethylamine and di-n-butylamine, tertiary amines such as triethylamine and methyldiethylamine, alcohol amines such as dimethylethanolamine and triethanolamine, quaternary ammonium salts such as tetramethylammonium hydroxide and tetraethylammonium hydroxide, and cyclic amines such as pyrrole and piperidine.

In this alkaline aqueous solution, an alcohol and a surfactant may also be added each in an appropriate amount.

The alkali concentration of the alkali developer is usually from 0.1 to 20 mass%.

The pH of the alkali developer is usually from 10.0 to 15.0.

As for the rinsing solution, pure water or pure water in which an appropriate amount of surfactant is added may be used.

After the development or rinsing, the developer or rinsing solution adhering on the pattern may removed by a supercritical fluid.

In the immersion exposure using the protective film of the present invention, the resist is not particularly limited and may be arbitrarily selected from those usually employed. The resist may be either positive or negative.

As for the resist, positive and negative resists capable of coping with recent ultrafine processing and fully satisfied in various required properties can be suitably used. In the present invention, a chemical amplification-type resist is preferred, and a positive resist is more preferred.

As for the chemical amplification-type resist, those using a so-called acid generator of generating an acid by the effect of active energy ray such as light are representative. For example, the negative chemical amplification-type resist usually uses a three-component system comprising a base polymer, a photoacid generator and a crosslinking agent. At the exposure of resist, an acid generated upon light irradiation acts to cause a crosslinking reaction in the exposed area and decrease the solubility in the developer. On the other hand, the positive chemical amplification-type resist includes a resist using a two-component system comprising a base polymer having a moiety blocked with a protective group of exerting a dissolution-inhibiting function and a photoacid generator, and a resist using a three-component system comprising a base polymer, an acid generator and a dissolution inhibitor. At the exposure of resist, an acid generated upon light irradiation acts to remove the protective group of the polymer and elevate the solubility in the developer.

In the case where the exposure light source is an ArF excimer laser (wavelength: 193 nm), a resist using a two-component system comprising a photoacid generator and a resin which is solubilized in an alkali developer under the action of an acid is preferred.

In particular, the resin which is solubilized in an alkali developer under the action of an acid is preferably an acrylic or methacrylic resin having a monocyclic or polycyclic alicyclic hydrocarbon structure, and the resin more preferably further has a lactone residue or an adamantane residue.

Incidentally, since the resist pattern formed preferably has no electrical conductivity, the resist preferably contains no metal. The metal content is preferably 100 ppb or less, more preferably 50 ppb or less. The metal content can be decreased by elevating the purity of materials used or by normal purification such as filtration.

## Examples

The present invention is described in greater detail below by referring to Examples, but the present invention should not be construed as being limited thereto.

[Synthesis Example 1: Synthesis of Resin 1]

Methacrylic acid and n-hexane methacrylic ester were charged at a ratio of 50/50 (by mol) and dissolved in tetrahydrofuran to prepare 130 g of a solution having a solid content concentration of 20 mass%.

To this solution, 20 mol% of a polymerization initiator V-65 (2,2'-azobis(2,4-dimethylvaleronitrile)) produced by

Wako Pure Chemical Industries, Ltd. was added. The resulting solution was added dropwise to 10 g of tetrahydrofuran heated to 65°C over 2 hours in a nitrogen atmosphere. After the completion of dropwise addition, the reaction solution was stirred for 4 hours. When the reaction was completed, the reaction solution was cooled to room temperature and crystallized in 1 L of a hexane solvent, and the precipitated white powder was collected by filtration to obtain 12 g of the objective Resin 1. The standard polystyrene-reduced weight average molecular weight (Mw) as determined by the GPC measurement was 9,000, and the dispersity (Mw/Mn) was 1.8.

Resin 2 shown in Table 1 below was synthesized in the same manner as Resin 1 except that the ratio of methacrylic acid and n-hexane methacrylic ester charged was changed to 40/60 (by mol) and the amount of the polymerization initiator was changed to 30 mol%.

Resins 3 and 4 were synthesized in the same manner as above except for changing the monomer.

Resin 5 was PR-54046 (cresol novolak resin) produced by Sumitomo Bakelite Co., Ltd.

[Synthesis Example 2: Synthesis of Resin 6]

Vinyl acetate and 1-trifluoromethylvinyl acetate at a ratio of 50/50 (by mol) were charged in an amount of 120 g and stirred under heating at 65°C in a nitrogen atmosphere. To this solution, 3 mol% of a polymerization initiator V-65 (2,2'-azobis(2,4-dimethylvaleronitrile)) produced by Wako Pure Chemical Industries, Ltd. was added and further stirred for 12 hours. When the reaction was completed, the reaction solution was cooled to room temperature and crystallized in 500 ml of a hexane solvent, and the precipitated white powder was collected by filtration to obtain 67 g of Resin 6a shown below.

Resin 6a:

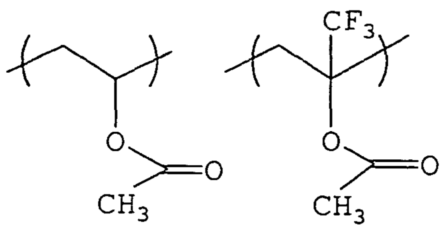

The thus-obtained Resin 6a was dissolved in 500 ml of methanol/water (1/1 by mass) and after adding 1 ml of sulfuric acid, the resulting solution was refluxed under heating at 100°C for 6 hours. When the reaction was completed, the reaction product was extracted with ethyl acetate, and dried and concentrated on magnesium sulfate to obtain 30 g of Resin 6. The standard polystyrene-reduced weight average molecular weight (Mw) as determined by the GPC measurement was 4,000, and the dispersity (Mw/Mn) was 1.6.

[Synthesis Example 6: Synthesis of Resin 7]

A 150 ml 1,1,2-trichloro-trifluoroethylene solution containing 26 g of 5-(2-hexafluoroisopropanol)norbornene was charged into a 1 L-volume autoclave and pressurized to 200 psi in a nitrogen atmosphere. Furthermore, 20 g (0.20 mol) of tetrafluoroethylene was poured therein and the resulting solution was heated to 50°C with stirring. In this reaction solution, a 150 ml 1,1,2-trichloro-trifluoroethylene solution containing 1.2 g of di(4-tert-butylcyclohexyl)peroxy dicarbonate was poured over 20 minutes, and stirring was further continued for 20 hours. When the reaction was completed, the reaction solution was charged into 2 L of methanol with vigorous stirring to precipitate a white resin. The weight average molecular weight of the obtained powder as determined by the GPC measurement was 6,000, and the dispersity was 1.4. Also, from the 1H-NMR, 13C-NMR and 19F-NMR analyses, the molar compositional ratio of tetrafluoroethylene/5-(2-hexafluoroisopropanol)norbornene was 50/50.

[Synthesis Example 7: Synthesis of Resin 8]

Monomer (A) shown below (72 g) was dissolved in 500 ml of toluene and to the resulting solution under stirring at room temperature in a nitrogen atmosphere, 0.1 ml of boron trifluoride was added and stirred as-is for 6 hours. When the reaction was completed, the reaction solution was crystallized in 1 L of a hexane solvent and the precipitated white powder was collected by filtration to obtain 65 g of the objective Resin 8. The standard polystyrene-reduced weight

average molecular weight (Mw) as determined by the GPC measurement was 20,000, and the dispersity (Mw/Mn) was 1.7.

(A):

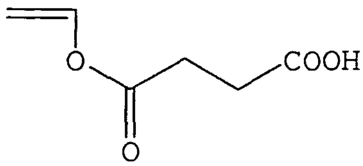

[Synthesis of Comparative Resins C1 to C4]

Comparative Resins C1 to C4 were synthesized in the same manner as Resin 1 or 3 by changing the ratio of monomers charged and the amount of initiator.

The content of low-molecular components having a molecular weight of 3,000 or less and the acid value (milli-equivalent/g) of each resin are shown together with molecular weight and dispersity in Table 1 below.

Table 1

| | | Structure | Compositional Ratio | Molecular Weight | Dispersity | Low-Molecular Component (mass%) | Acid Value |
|---|---|---|---|---|---|---|---|
| Resin | 1 | (I-1) | 50/50 | 9,000 | 1.8 | 2 | 3.9 |
| | 2 | (I-1) | 40/60 | 5,000 | 1.7 | 2 | 2.9 |
| | 3 | (1-7) | 70/30 | 18,000 | 1.8 | 3 | 3.2 |
| | 4 | (II-7) | 100 | 8,000 | 1.4 | 1 | 3.7 |
| | 5 | (III-1) | 100 | 10,000 | 1.6 | 5 | 7.3 |
| | 6 | (IV-1) | 50/50 | 4,000 | 1.6 | 7 | 6.4 |
| | 7 | (VI-4) | 50/50 | 6,000 | 1.4 | 2 | 2.8 |
| | 8 | (VII-1) | 100 | 20,000 | 1.7 | 4 | 6.9 |
| Comparative Resin | C1 | (I-1) | 25/85 | 10,000 | 1.8 | 2 | 1.5 |
| | C2 | (I-1) | 60/40 | 11,000 | 2.0 | 2 | 8.7 |
| | C3 | (I-7) | 50/50 | 10,000 | 1.9 | 3 | 1.6 |
| | C3 | (1-7) | 95/5 | 15,000 | 1.9 | 3 | 8.7 |

[Examples 1 to 8 and Comparative Examples 1 to 4: Aptitude Evaluation of Protective Film for Immersion Exposure]

<Preparation of Protective Film-Forming Composition>

The components shown in Table 2 below were dissolved in a solvent (propylene glycol monomethyl ether) to prepare a solution having a solid content concentration of 10 mass%, and this solution was filtered through a polyethylene filter having a pore diameter of 0.1 μm to prepare a protective film-forming composition. The prepared protective film-forming composition was evaluated by the following methods and the results are shown in Table 2.

[Water Insolubility]

The protective film-forming composition was coated on a silicon wafer and dried, and the film thickness was measured. Thereafter, the film was dipped in pure water at 23°C for 10 hours and dried, and again the film thickness was measured. The difference from the initial film thickness was evaluated. The film thickness decreases when the film dissolves in water, and increases when the film swells with water. As the absolute value is smaller, the water insolubility is higher.

[Removability with Alkali]

The protective film-forming composition was coated on a silicon wafer to a film thickness of 100 nm and dried, the film was dipped in an alkali developer 23°C and dried, and the film thickness was again measured. The removability with alkali was rated ○ when the film thickness became 0 within 5 seconds, and rated × when the film was not dissolved within 5 seconds.

<Striation>

The protective film-forming composition was coated on a silicon wafer to a film thickness of 50 nm and dried, and the formed protective film was observed by an optical microscope. The wet remaining and the generation of striation were evaluated with an eye and rated × when these were very conspicuously observed, rated Δ when slightly observed, rated ○ when scarcely observed, and rated ◎ when not observed at all.

Incidentally, the striation means a phenomenon that streaks radiating from the wafer center appear, and this is a phenomenon where a portion having a small coating film thickness and a portion having a large coating film thickness are alternately distributed like radial streaks.

<Coating Uniformity in Substrate Plane>

The protective film-forming composition was coated on a silicon wafer to a film thickness of 50 nm and dried, and the film thickness value of the formed protective film was measured at arbitrary 10 points on the silicon wafer by an Alpha-Step-100 (manufactured by TENVCOR). The dispersion of the measured values with respect to the target film thickness was evaluated as the index for coating uniformity.

Table 2

| | | Protective Film | | Evaluation of Water Insolubility, Å(angstrom) | Removability with Alkali | Striation | Coating Uniformity |
|---|---|---|---|---|---|---|---|
| | | Resin | Surfactant | | | | |
| Example | 1 | 1 | none | 0 | ○ | ○ | ○ |
| | 2 | 2 | none | 0 | ○ | ○ | ○ |
| | 3 | 3 | none | 0 | ○ | O | ○ |
| | 4 | 4 | W-1 | 0 | ○ | ◎ | ◎ |
| | 5 | 5 | none | 4 | ○ | ○ | ○ |
| | 6 | 6 | W-2 | 2 | ○ | ◎ | ◎ |
| | 7 | 7 | none | 0 | ○ | ○ | ○ |
| | 8 | 8 | none | 10 | ○ | ○ | ○ |
| Comparative Example | 1 | C1 | none | 0 | × | ○ | ○ |
| | 2 | C2 | none | 30 | ○ | ○ | ○ |
| | 3 | C3 | none | 0 | × | ○ | ○ |
| | 4 | C4 | none | 20 | ○ | ○ | ○ |

The symbols in Table 2 denote the followings:

W-1: Megafac F176 (produced by Dainippon Ink & Chemicals, Inc.) (containing fluorine)
W-2: Megafac R08 (produced by Dainippon Ink & Chemicals, Inc.) (containing fluorine and silicon)

It is seen that the protective film-forming composition of the present invention is good in both water insolubility and removability with alkali and by the addition of an surfactant, is enhanced in the striation and coating uniformity.

[Examples 9 to 20 and Comparative Examples 5 to 8: Evaluation of Immersion Exposure]

<Evaluation of Image Formation>

An organic antireflection film ARC29A (produced by (produced by Nissan Chemical Industries, Ltd.) was coated on a silicon wafer and baked at 205°C for 60 seconds to form a 78-nm antireflection film. On this film, the resist shown in Table 3 was coated and baked at 115°C for 60 seconds to form a 200 nm-thick resist film. In Examples 9 to 20, a protective film-forming composition (solid content concentration: 4 mass%) containing the components shown in Table 3 was further coated and baked at 90°C for 60 seconds to form a 30 nm-thick protective film. In Comparative Examples 5 to 8, the protective film was not formed.

The thus-obtained wafer was subjected to two-beam interference exposure in an apparatus shown in Fig. 1 by using water as the immersion solution. The wavelength of the laser used was 193 nm. Thereafter, the resist film was heated at 130°C for 60 seconds, then developed with an aqueous tetramethylammonium hydroxide solution (2.38%) for 60 seconds and after rinsing with pure water, spin-dried to obtain a resist pattern.

The obtained pattern was observed by a scanning electron microscope (S-9260, manufactured by Hitachi Ltd.), and this was rated 0 when the pattern did not fall down at all, and rated × when the pattern entirely fell down. Also, the pattern profile was observed.

In the apparatus shown in Fig. 1, 1 is a laser, 2 is a diaphragm, 3 is a shutter, 4, 5 and 6 each is a reflecting mirror, 7 is a condenser lens, 8 is a prism, 9 is an immersion liquid, 10 is a wafer having provided thereon antireflection film, resist film and protective film (in Comparative Examples 5 to 8, the protective film was not provided), and 11 is a wafer stage.

Table 3

| | Protective Film-Forming Composition | | | Resist | Image Forming Property | |
|---|---|---|---|---|---|---|
| | Resin, 0.8 g | Surfactant, 100 ppm | Solvent (mass ratio) | | Falling Down of Pattern | Profile |
| Example 9 | 2 | none | SL-1 | PR1 | ○ | rectangular |
| Example 10 | 2 | none | SL-1 | PR2 | ○ | slightly tapered |
| Example 11 | 2 | none | SL-1 | PR3 | ○ | rectangular |
| Example 12 | 2 | none | SL-1 | PR4 | ○ | rectangular |
| Example 13 | 4 | W-1 | SL-2/SL-3 (2/8) | PR1 | ○ | rectangular |
| Example 14 | 4 | W-1 | SL-2/SL-3 (2/8) | PR2 | ○ | rectangular |
| Example 15 | 4 | W-1 | SL-2/SL-3 (2/8) | PR3 | ○ | slightly tapered |
| Example 16 | 4 | W-1 | SL-2/SL-3 (2/8) | PR4 | ○ | rectangular |
| Example 17 | 7 | none | SL-3/SL-4 (8/2) | PR1 | ○ | rectangular |
| Example 18 | 7 | none | SL-3/SL-4 (8/2) | PR2 | ○ | rectangular |
| Example 19 | 7 | none | SL-3/SL-4 (8/2) | PR3 | ○ | rectangular |
| Example 20 | 7 | none | SL-3/SL-4 (8/2) | PR4 | ○ | rectangular |
| Comparative Example 5 | none | | | PR1 | × | - |
| Comparative Example 6 | none | | | PR2 | × | - |
| Comparative Example 7 | none | | | PR3 | × | - |
| Comparative Example 8 | none | | | PR4 | × | - |

The symbols in Table 3 denote the followings:

[Solvent]

SL-1: Isopar G

SL-2: hexafluorobenzene

SL-3: perfluorobutyltetrahydrofuran

SL-4: propylene glycol monomethyl ether acetate

[Resist]

PR1: the resist composition described in Example 1 of JP-A-2000-275845, that is, a resist composition comprising 10 parts by mass of Resin P-1 shown below (weight average molecular weight: about 10,000), 0.2 parts by mass of an acid generator (triphenylsulfonium perfluorobutanesulfonate ("TPS-109", produced by Midori Kagaku Co., Ltd.)), 0.015 parts by mass of a basic compound (2,6-diisopropyl-aniline), and solvents (47.5 parts by mass of propylene glycol monomethyl ether acetate and 2.5 parts by mass of γ-butyrolactone).

(P-1):

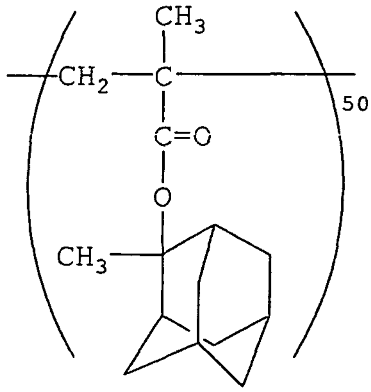

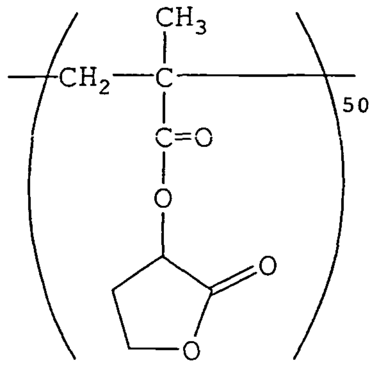

PR2: the resist composition described in Example 1 of JP-A-2003-167347, that is, a resist composition comprising 100 parts by mass of Resin P-2 shown below (weight average molecular weight: 10,000), 2 parts by mass of an acid generator component (triphenylsulfonium nonafluorobutanesulfonate), 0.2 parts by mass of a basic compound (triethanolamine), and organic solvents (750 parts by mass of propylene glycol monomethyl ether acetate and 30 parts by mass of γ-butyrolactone).

(P-2) :

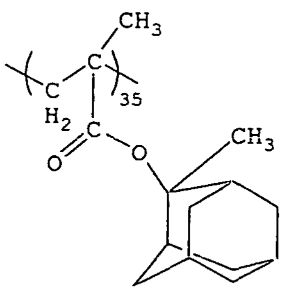

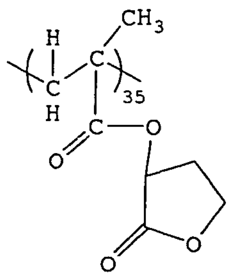

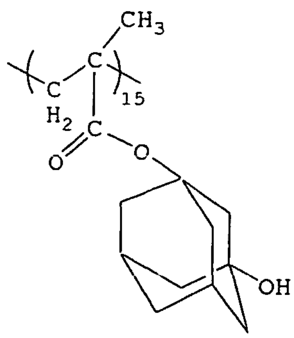

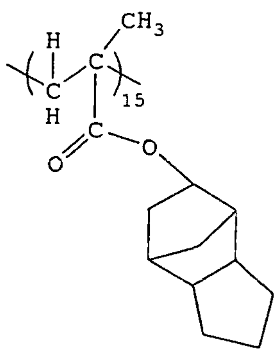

PR3: the resist composition described in Example 1 of JP-A-2002-12622, that is, a resist composition comprising 80 parts by mass of Resin P-3 shown below (weight average molecular weight: 12,200), 1 part by mass of an acid generator (PAG1), 0.078 parts by mass of a basic compound (tributylamine), and 480 parts by mass of a solvent (PGMEA: propylene glycol monomethyl ether acetate).

(P-3) :

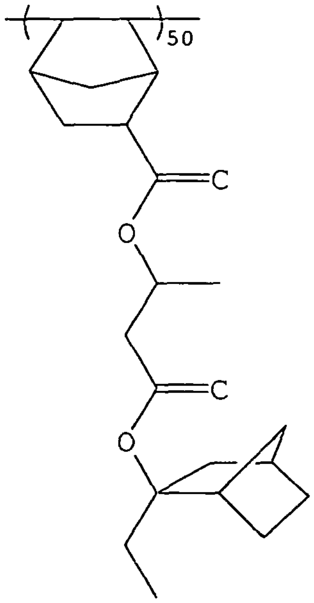

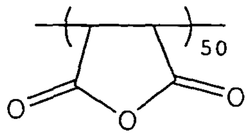

(PAG1) :

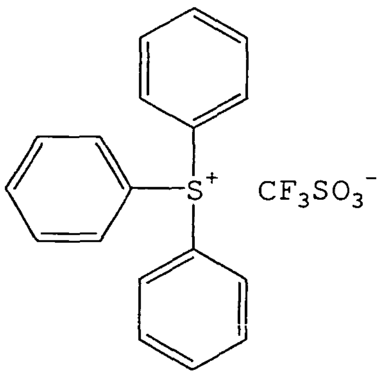

PR4: the resist composition described in Example 1 of JP-A-2003-177538, that is, a resist composition comprising 2 g of Resin P-4 shown below (weight average molecular weight: 10,600), 38 mg of an acid generator (PAG2), 4 mg of a basic compound (1,5-diazabicyclo[4.3.0]-5-nonene (DBN)), 10 g of a surfactant (Megafac F176 (produced by Dainippon Ink & Chemicals, Inc.)), and a solvent (propylene glycol monomethyl ether acetate (PGMEA)/ethyl lactate = 70/30, solid content concentration: 14 mass%).

(P-4) :

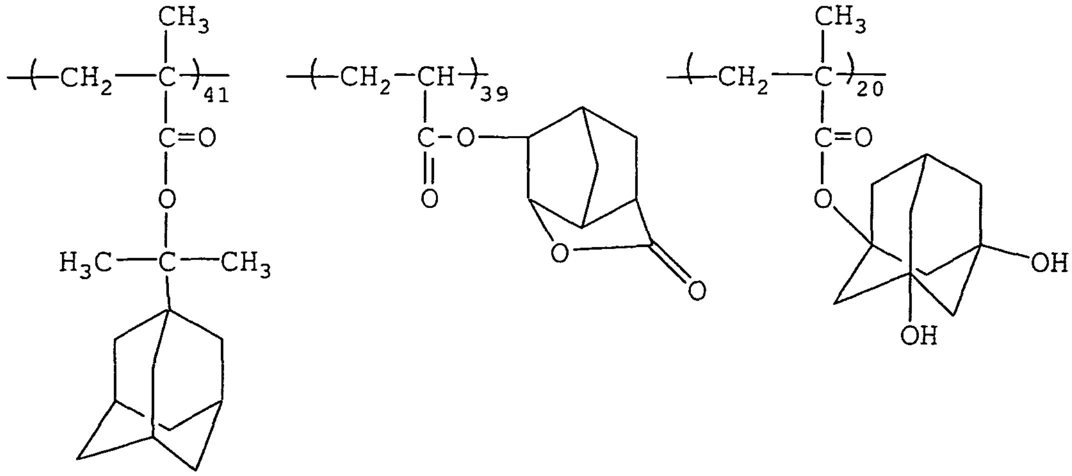

(PAG2) :

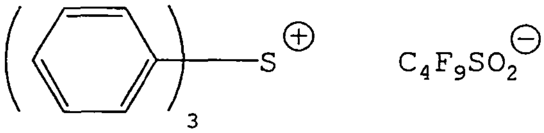

As seen in Table 2, the protective film-forming composition of the present invention has sufficiently high water insolubility as a protective film and at the same time, has satisfactory solubility in an alkali developer. That is, the pattern was obtained by protecting the resist film with the protective film at the immersion exposure, but as seen in Table 3, in Comparative Examples where the protective film was not formed, the resist pattern entirely fell down. In Comparative Examples, the pattern fell down and therefore, the pattern profile was not known.

Incidentally, when the protective film-forming composition used in Example 9 was changed to 1.2 g of the resin, 18.8 g of the solvent and a solid content concentration of 6 mass% and evaluated in the same manner as in Example 9 by using PR1 as the resist, the profile was slightly tapered.

Also, when in Example 9, the heating after coating of the protective film-forming composition was performed at 120°C to form a protective film and the film was evaluated, a part of the pattern fell down.

It is seen from these results that according to the protective film-forming composition of the present invention, the permeation of the immersion liquid into the inside of the resist film and the dissolving out of the resist film components into the immersion liquid can be prevented without complicating the processing step at the immersion exposure and an objective fine pattern can be obtained.

## Claims

1. A pattern forming method comprising: forming a resist film; forming a protective film on said resist film by using a protective film-forming composition; and subjecting said resist film to immersion exposure through said protective film and then to development, **characterized in that** the protective film-forming composition comprises a water-insoluble alkali-soluble resin having an acid value of 2.0 to 8.0 milli-equivalent/g.

2. The pattern forming method as defined in claim 1, wherein said protective film is formed by coating said protective film-forming composition and heating the coating at 60 to 100°C.

3. The pattern forming method as claimed in claim 1, wherein said protective film-forming composition further comprises a surfactant.

4. The pattern forming method as claimed in claim 1, wherein the solid content concentration of said protective film-forming composition is from 1 to 5 mass%.

5. The pattern forming method as claimed in claim 1, wherein the content of compounds having a molecular weight of 3,000 or less in said water-insoluble alkali-soluble resin is 5 mass% or less.

6. The pattern forming method as claimed in claim 1, wherein said water-insoluble alkali-soluble resin contains a repeating unit represented by any one of the following formulae (IV) to (VI):

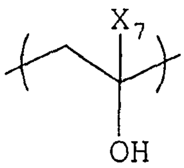

(IV)

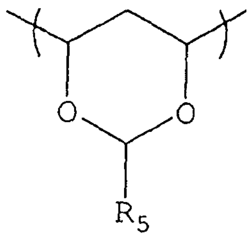

(V)

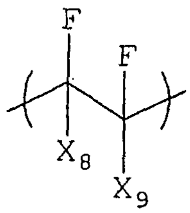

(VI)

wherein $R_5$ represents an alkali-soluble group or an organic group; $X_7$ represents a hydrogen atom, a methyl group, a halogen atom or a methyl halide group; $X_8$ and $X_9$ each independently represents a hydrogen atom, a fluorine atom or a fluorinated alkyl group.

7. The pattern forming method as claimed in claim 6, wherein in the formula (V), the alkali-soluble group as $R_5$ is a carboxylic acid group or a fluorinated alcohol group.

**Patentansprüche**

1. Strukturbildendes Verfahren, umfassend: Bilden eines Fotolackfilms; Bilden eines Schutzfilms auf dem Fotolackfilm unter Verwendung einer Schutzfilm-bildenden Zusammensetzung; und Unterziehen des Fotolackfilms unter eine Immersionsbelichtung durch den Schutzfilm und dann unter eine Entwicklung, **dadurch gekennzeichnet, dass** die Schutzfilm-bildende Zusammensetzung ein wasserunlösliches, alkalilösliches Harz mit einem Säurewert von 2,0 bis 8,0 Milliäquivalent/g umfasst.

2. Strukturbildendes Verfahren gemäß Anspruch 1, worin der Schutzfilm durch Beschichten der Schutzfilm-bildenden Zusammensetzung und Erwärmen der Beschichtung bei 60 bis 100°C gebildet wird.

3. Strukturbildendes Verfahren gemäß Anspruch 1, worin die Schutzfilm-bildende Zusammensetzung ferner ein Tensid umfasst.

4. Strukturbildendes Verfahren gemäß Anspruch 1, worin der Feststoffgehalt der Schutzfilm-bildenden Zusammensetzung von 1 bis 5 Masse% beträgt.

5. Strukturbildendes Verfahren gemäß Anspruch 1, worin der Mengenanteil der Verbindungen mit einem Molekulargewicht von 3.000 oder kleiner in dem wasserunlöslichen, alkalilöslichen Harz 5 Masse% oder weniger beträgt.

6. Strukturbildendes Verfahren gemäß Anspruch 1, worin das wasserunlösliche, alkalilösliche Harz eine durch gemäß irgendeine der folgenden Formel (IV) bis (VI) dargestellte Wiederholungseinheit enthält:

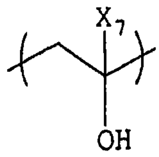

(IV)

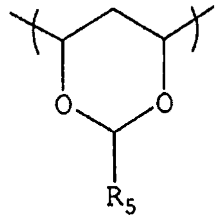

(V)

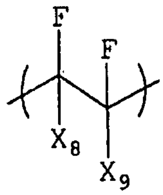

(VI)

worin $R_5$ eine alkalilösliche Gruppe oder eine organische Gruppe darstellt; $X_7$ ein Wasserstoffatom, eine Methylgruppe, ein Halogenatom oder eine Methylhalogenidgruppe darstellt; $X_8$ und $X_9$ jeweils unabhängig ein Wasserstoffatom, ein Fluoratom oder eine fluorierte Alkylgruppe darstellen.

7. Strukturbildendes Verfahren gemäß Anspruch 6, worin in der Formel (V) $R_5$ als alkalilösliche Gruppe eine Carbonsäuregruppe oder eine fluorierte Alkoholgruppe ist.

## Revendications

1. Procédé de formation de tracé comprenant : la formation d'un film d'épargne ; la formation d'un film de protection sur ledit film d'épargne en utilisant une composition de formation de film de protection ; et la soumission dudit film d'épargne à une exposition par immersion à travers ledit film de protection et ensuite à une révélation, **caractérisé en ce que** la composition de formation de film de protection comprend une résine insoluble dans l'eau soluble dans les alcalis ayant un indice d'acide de 2,0 à 8,0 milliéquivalents/g.

2. Procédé de formation de tracé selon la revendication 1, dans lequel ledit film de protection est formé par revêtement de ladite composition de formation de film de protection et chauffage du revêtement à 60 à 100°C.

3. Procédé de formation de tracé selon la revendication 1, dans lequel ladite composition de formation de film de protection comprend en outre un agent tensioactif.

4. Procédé de formation de tracé selon la revendication 1, dans lequel la concentration de teneur en solides de ladite composition de formation de film de protection est de 1 à 5% en masse.

5. Procédé de formation de tracé selon la revendication 1, dans lequel la teneur de composés ayant un poids moléculaire de 3 000 ou moins dans ladite résine insoluble dans l'eau soluble dans les alcalis est 5% en masse ou moins.

6. Procédé de formation de tracé selon la revendication 1, dans lequel ladite résine insoluble dans l'eau soluble dans les alcalis contient une unité répétitive représentée par l'une quelconque des formules (IV) à (VI) suivantes :

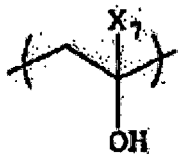

(IV)

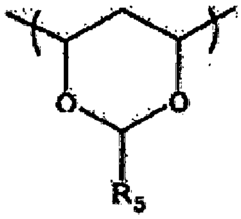

(V)

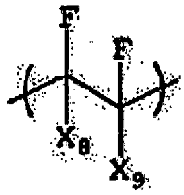

(VI)

dans lesquelles $R_5$ représente un groupe soluble dans les alcalis ou un groupe organique ; $X_7$ représente un atome d'hydrogène, un groupe méthyle, un atome d'halogène ou un groupe halogénure de méthyle ; $X_8$ et $X_9$ représentent chacun indépendamment un atome d'hydrogène, un atome de fluor ou un groupe alkyle fluoré.

**7.** Procédé de formation de tracé selon la revendication 6, dans lequel, dans la formule (V), le groupe soluble dans les alcalis comme $R_5$ est un groupe acide carboxylique ou un groupe alcool fluoré.

Fig. 1

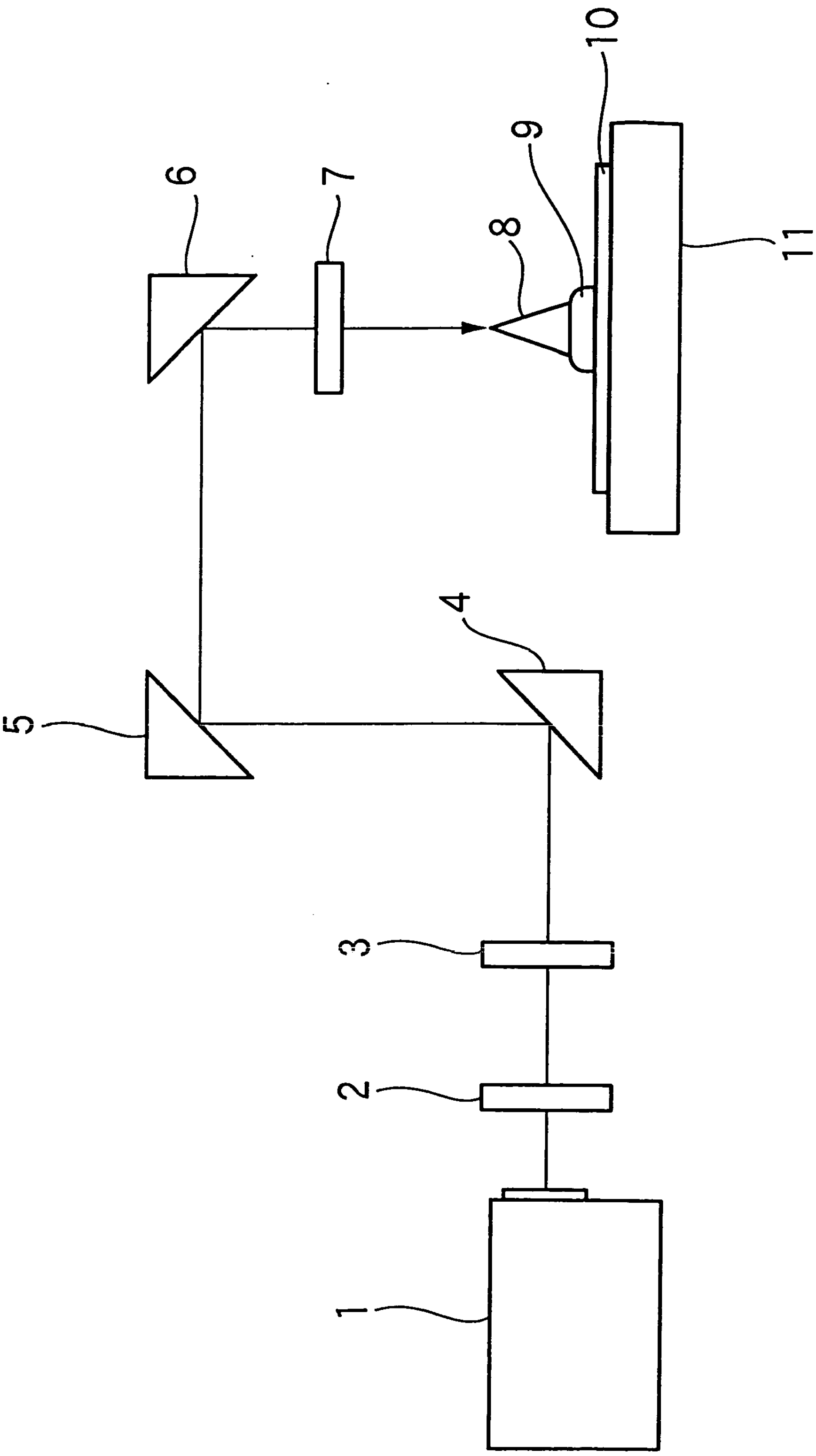

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 57153433 B
- JP 7220990 A
- JP 6124873 A
- JP 10303114 A
- JP 62036663 A
- JP 61226746 A
- JP 61226745 A
- JP 62170950 A
- JP 63034540 A
- JP 7230165 A
- JP 8062834 A
- JP 9054432 A
- JP 9005988 A
- JP 2002277862 A
- US 5405720 A
- US 5360692 A
- US 5529881 A
- US 5296330 A
- US 5436098 A
- US 5576143 A
- US 5294511 A
- US 5824451 A
- JP 2002090991 A
- JP 7069611 B
- US 6294680 B
- JP 6118631 A
- JP 6118656 A
- JP 8087115 A
- JP 8179509 A
- JP 2000275845 A
- JP 2003167347 A
- JP 2002012622 A
- JP 2003177538 A

### Non-patent literature cited in the description

- *SPIE Proc.,* 2002, vol. 4688, 11
- *J. Vac. Sci. Tecnol. B,* 1999, 17
- *Nikkei Microdevice,* April 2004
- **M. SATO.** TOK Resist & Material Development Status for Immersion Lithography. *Litho Forum, Los Angeles,* 28 January 2004